# EUROPEAN PATENT APPLICATION

(11) **EP 2 728 975 A1**
(43) Date of publication of application: **07.05.2014**
(21) Application number: 12191204.2
(22) Date of filing: 05.11.2012
(51) Int. Cl.: H05K 1/02, H05K 3/40

(54) **Led cooling structure**

(71) Applicant: Yeh, Chao-Chin, 500 Changhua County (TW)
(72) Inventor: Yeh, Chao-Chin, 500 Changhua County (TW)
(74) Representative: Becker Kurig Straus

(57) **Abstract**

A LED cooling structure includes a substrate (10) having a circuit layout (11) and one or a number of thermally conductive plates (14) arranged on the top wall thereof, one or a plurality of through holes (12) cut through the opposing top and bottom walls thereof and a thermally conductive post (13) mounted in each through hole (12) and connected with the thermally conductive plates (14), and one or a number of light-emitting devices (20) mounted at the substrate (10) and electrically connected to the circuit layout (11) with the bottom side thereof kept in contact with one respective thermally conductive plate (14) for quick dissipation of heat.

## Description

### BACKGROUND OF THE INVENTION

### 1. Field of the Invention

The present invention relates to LED technology and more particularly, to a LED cooling structure.

### 2. Description of the Related Art

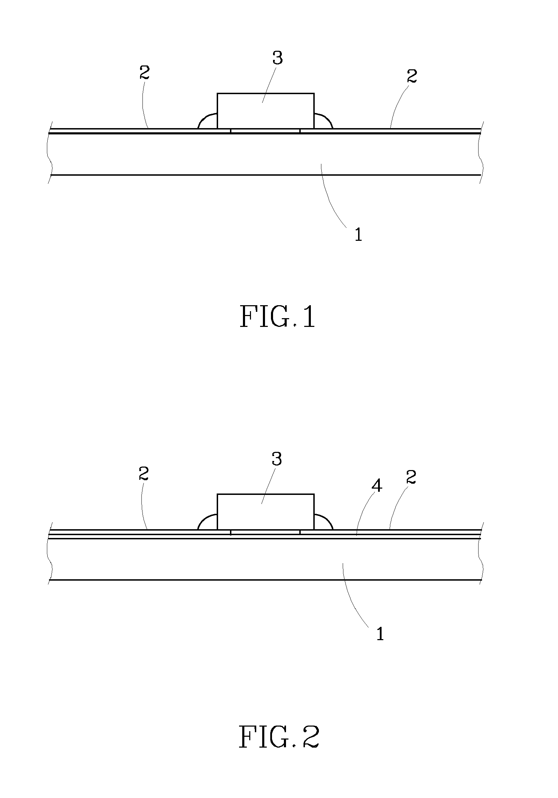

FIG. 1 illustrates the basic structure of a conventional LED lamp, which comprises a substrate **1** formed of, for example, a printed circuit board, a circuit layout **2** arranged on the substrate **1,** and a light-emitting device **3** mounted at the substrate **1** and electrically connected to the circuit layout **2.** This design of LED lamp encounters a heat dissipation problem. During operation of the light-emitting device **3** to give off light, waste heat will be produced. However, the printed circuit board **1** is made of a plastic material that is not a good heat transfer material. Waste heat generated by the light-emitting device **3** cannot be rapidly and effectively dissipated.

FIG. 2 illustrates the base structure of another prior art design of LED lamp, which comprises a substrate **1** made of aluminum alloy and generally known as the aluminum substrate, an insulative layer **4** covered on the substrate **1,** a circuit layout **2** arranged on the insulative layer **4,** and a light-emitting device **3** mounted at the insulative layer **4** and electrically connected to the circuit layout **2.** This design uses a high thermal conductivity aluminum substrate to substitute for a printed circuit board. Thus, an insulative layer **4** must be provided between the aluminum substrate **1** and the circuit layout **2** so that the circuit layout **2** can function normally. The insulative layer **4** is generally made of an electrically and thermally insulative material that isolates transmission of heat energy. In consequence, the aluminum substrate gives little help in dissipating heat from the light-emitting device **3.**

### SUMMARY OF THE INVENTION

The present invention has been accomplished under the circumstances in view. It is the main object of the present invention to provide a LED cooling structure, which rapidly and effectively transfers and dissipates heat.

To achieve this and other objects of the present invention, a LED cooling structure comprises a substrate, which comprises opposing top and bottom walls, a circuit layout and at least one thermally conductive plate arranged on the top wall, at least one through hole cut through the top and bottom walls, and a thermally conductive post mounted in each through hole and having its one end connected with the at least one thermally conductive plate, and at least one light-emitting device mounted at the substrate and electrically connected to the circuit layout, each light-emitting device having a bottom side thereof disposed in contact with one thermally conductive plate for dissipation of heat.

Further, the substrate can be an aluminum substrate, and the thermally conductive post in each through hole can be formed integral with the aluminum substrate.

Further, a metal plate can be arranged at the bottom wall of the substrate, and the thermally conductive post in each through hole can be formed integral with the metal plate.

Further multiple light-emitting devices can be mounted at the substrate and respectively connected to respective thermally conductive plates that are arranged around one respective through hole and one respective thermally conductive post.

Other advantages and features of the present invention will be fully understood by reference to the following specification in conjunction with the accompanying drawings, in which like reference signs denote like components of structure.

### BRIEF DESCRIPTION OF THE DRAWINGS

FIG. 1 is a schematic sectional view of a LED lamp according to the prior art.
FIG. 2 is a schematic sectional view of another design of LED lamp according to the prior art.
FIG. 3 is a schematic sectional view of a LED cooling structure in accordance with a first embodiment of the present invention.
FIG. 4 is a top view of FIG. 3.
FIG. 5 is a schematic sectional view of a LED cooling structure in accordance with a second embodiment of the present invention.

### DETAILED DESCRIPTION OF THE INVENTION

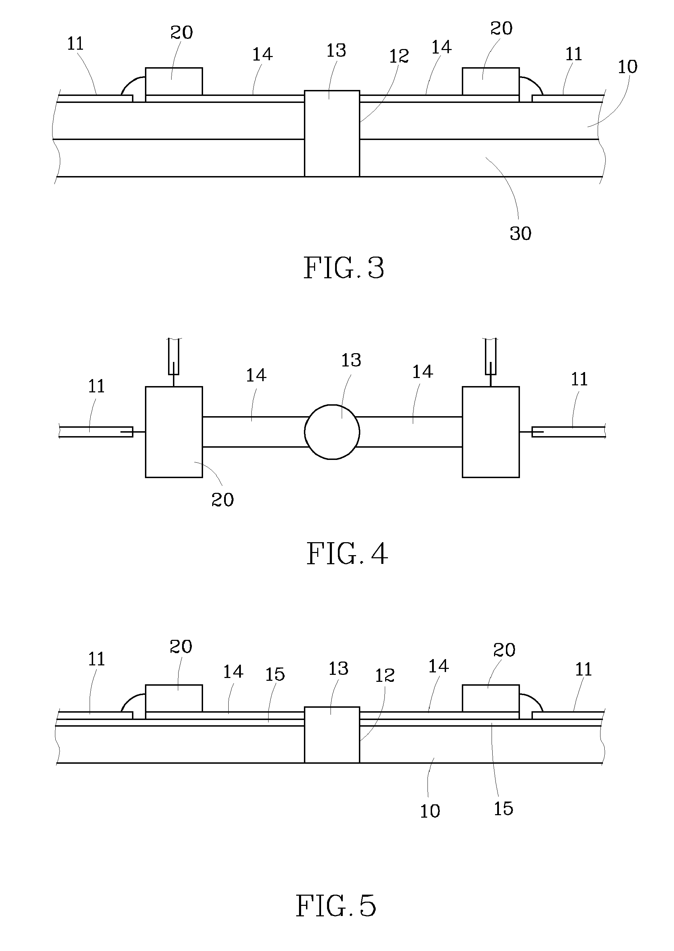

Referring to FIGS. 3 and 4, a LED cooling structure in accordance with a first embodiment of the present invention is shown. The LED cooling structure comprises a substrate **10,** at least one light-emitting device **20,** and a metal plate **30.**

The substrate **10** can be a printed circuit board or aluminum substrate. In this embodiment, the substrate **10** is a printed circuit board, comprising a circuit layout **11** and at least one thermally conductive plate **14** arranged on the top wall thereof, at least one through hole **12** cut through the opposing top and bottom walls thereof, and a thermally conductive post **13** mounted in each through hole **12.** Further, the at least one thermally conductive plate **14** can be formed integral with the printed circuit board during the fabrication of the printed circuit board. Further, the thermally conductive post **13** in each through hole **12** can be a rivet, copper post or iron post, having its one end connected to the at least one thermally conductive plate **14** by bonding, welding or riveting.

The at least one light-emitting device **20** is mounted at the substrate **10** and electrically connected to the circuit layout **11.** Each light-emitting device **20** has its bottom side arranged on the at least one thermally conductive plate **14** so that waste heat generated by the at least one light-emitting device **20** can be transferred toward the outside by the at least one thermally conductive plate **14.**

The metal plate **30** is made of copper, iron, or any other high conductivity metal material, and mounted at the bottom wall of the substrate **10** and connected with the thermally conductive post **13** in each through hole **12** by bonding, welding or riveting. Further, the thermally conductive post **13** can be formed of a part of the metal plate **30** directly using a stamping technique.

According to the aforesaid first embodiment of the present invention, each light-emitting device **20** has its bottom side kept in direct contact with the at least one thermally conductive plate **14.** Thus, during operation of the at least one light-emitting device **20** to give off light, waste heat generated by the at least one light-emitting device **20** can be effectively and rapidly transferred by the at least one thermally conductive plate **14** through the thermally conductive post **13** in each through hole **12** to the metal plate **30** for quick dissipation into the outside open air. Further, the location of the at least one through hole **12** is preferably adjacent to the at least one light-emitting device **20,** so that the thermally conductive post **13** can achieve the best results.

Referring to FIG. 5, a LED cooling structure in accordance with a second embodiment of the present invention is shown. The LED cooling structure comprises a substrate **10,** and at least one light-emitting device **20.**

The substrate **10** can be a printed circuit board or aluminum substrate. In this embodiment, the substrate **10** is an aluminum substrate, comprising an insulative layer **15** arranged on the top wall thereof, a circuit layout **11** and at least one thermally conductive plate **14** arranged on the insulative layer **15,** at least one through hole **12** cut through the opposing top and bottom walls thereof, and a thermally conductive post **13** mounted in each through hole **12** and connected with the at least one thermally conductive plate **14.** Further, each thermally conductive plate **14** can be a metal plate, for example, copper plate. Further, the thermally conductive post **13** in each through hole **12** can be a rivet, copper post or iron post, having its one end connected to the at least one thermally conductive plate **14** by bonding, welding or riveting.

The at least one light-emitting device **20** is mounted at the substrate **10** and electrically connected to the circuit layout **11.** Each light-emitting device **20** has its bottom side arranged on the at least one thermally conductive plate **14** so that waste heat generated by the at least one light-emitting device **20** can be transferred toward the outside by the at least one thermally conductive plate **14.**

According to the aforesaid second embodiment, the substrate is an aluminum substrate made of an aluminum alloy that has high thermal conductivity. During the operation of the at least one light-emitting device **20** to give off light, the insulative layer 15 isolates the waste heat generated by the at least one light-emitting device **20,** enabling the waste heat to be effectively and rapidly transferred through the least one thermally conductive plate **14** and the thermally conductive post **13** in each through hole **12** to the aluminum substrate **10** for quick dissipation.

Further, the thermally conductive post **13** in each through hole **12** can be formed integral with the aluminum substrate **10.**

Further, in either of the aforesaid first or second embodiment of the present invention, if multiple light-emitting devices are installed in the substrate, waste heat can be effectively and rapidly transferred by the at least one thermally conductive plate to the thermally conductive post in each through hole of the substrate. Further, the number of the at least one through hole is determined subject to actual requirements. For example, two light-emitting devices or three light-emitting devices can shape one through hole and one thermally conductive post, and these light-emitting devices are arranged around the through hole and the thermally conductive post.

Although particular embodiments of the invention have been described in detail for purposes of illustration, various modifications and enhancements may be made without departing from the spirit and scope of the invention. Accordingly, the invention is not to be limited except as by the appended claims.

## Claims

1. A LED cooling structure, comprising:
a substrate (10) comprising opposing top and bottom walls, a circuit (11) layout and at least one thermally conductive plate arranged on said top wall, at least one through hole (12) cut through said top and bottom walls, a thermally conductive post (13) mounted in each said through hole, the thermally conductive post (13) in each said through hole having one end thereof connected with said at least one thermally conductive plate (14); and
at least one light-emitting device (20) mounted at said substrate (10) and electrically connected to said circuit layout (11), each said light-emitting device having a bottom side thereof disposed in contact with one said thermally conductive plate (14) for dissipation of heat.

2. The LED cooling structure as claimed in claim 1, further comprising a metal plate (30) arranged at the bottom side of said substrate (10) and connected with the thermally conductive post (13) in each said through hole (12).

3. The LED cooling structure as claimed in claim 1, wherein said substrate (10) is a printed circuit board.

4. The LED cooling structure as claimed in claim 1, wherein each said thermally conductive plate (14) is a copper plate.

5. The LED cooling structure as claimed in claim 2, wherein the thermally conductive post (13) in each said through hole (12) is formed integral with said metal plate (30).

6. The LED cooling structure as claimed in claim 2, wherein the thermally conductive post (13) in each said through hole (12) is a rivet riveted to said metal plate (30).

7. A LED cooling structure, comprising:
a substrate (10) comprising opposing top and bottom walls, an insulative layer covering said top wall, a circuit layout (11) and at least one thermally conductive plate (14) arranged on said insulative layer, at least one through hole (12) cut through said top and bottom walls, a thermally conductive post (13) mounted in each said through hole (12), the thermally conductive post (13) in each said through hole having one end thereof connected with said at least one thermally conductive plate (14); and
at least one light-emitting device 20 mounted at said substrate (10) and electrically connected to said circuit layout (11), each said light-emitting device having a bottom side thereof disposed in contact with one said thermally conductive plate (14) for dissipation of heat.

8. The LED cooling structure as claimed in claim 7, wherein thermally conductive post (13) in each said through hole (12) is formed integral with said substrate (10).

9. The LED cooling structure as claimed in claim 8, wherein said substrate (10) is an aluminum substrate.

10. The LED cooling structure as claimed in claim 9, wherein the thermally conductive post (13) in each said through hole (12) is a rivet riveted to said aluminum substrate (10).

## Amended claims

### Amended claims in accordance with Rule 137(2) EPC.

**1.** A LED cooling structure, comprising:
a substrate (10) comprising opposing top and bottom walls, a circuit (11) layout and multiple thermally conductive plates arranged on said top wall, at least one through hole (12) cut through said top and bottom walls, a thermally conductive post (13) mounted in each said through hole, the thermally conductive post (13) in each said through hole having one end thereof connected with said multiple thermally conductive plates (14); and
at least one light-emitting device (20) mounted at said substrate (10) and electrically connected to said circuit layout (11), each said light-emitting device having a bottom side thereof disposed in contact with one said thermally conductive plate (14) for dissipation of heat.

**2.** The LED cooling structure as claimed in claim 1, further comprising a metal plate (30) arranged at the bottom side of said substrate (10) and connected with the thermally conductive post (13) in each said through hole (12).

**3.** The LED cooling structure as claimed in claim 1, wherein said substrate (10) is a printed circuit board.

**4.** The LED cooling structure as claimed in claim 1, wherein each said thermally conductive plate (14) is a copper plate.

**5.** The LED cooling structure as claimed in claim 2, wherein the thermally conductive post (13) in each said through hole (12) is formed integral with said metal plate (30).

**6.** The LED cooling structure as claimed in claim 2, wherein the thermally conductive post (13) in each said through hole (12) is a rivet riveted to said metal plate (30).

**7.** A LED cooling structure, comprising:
a substrate (10) comprising opposing top and bottom walls, an insulative layer covering said top wall, a circuit layout (11) and at least one thermally conductive plate (14) arranged on said insulative layer, at least one through hole (12) cut through said top and bottom walls, a thermally conductive post (13) mounted in each said through hole (12), the thermally conductive post (13) in each said through hole having one end thereof connected with said at least one thermally conductive plate (14); and
at least one light-emitting device 20 mounted at said substrate (10) and electrically connected to said circuit layout (11), each said light-emitting device having a bottom side thereof disposed in contact with one said thermally conductive plate (14) for dissipation of heat.

**8.** The LED cooling structure as claimed in claim 7, wherein thermally conductive post (13) in each said through hole (12) is formed integral with said substrate (10).

**9.** The LED cooling structure as claimed in claim 8, wherein said substrate (10) is an aluminum substrate.

**10.** The LED cooling structure as claimed in claim 9, wherein the thermally conductive post (13) in each said through hole (12) is a rivet riveted to said aluminum substrate (10).
